Europäisches Patentamt

(19) European Patent Office

Office européen des brevets

(11) Publication number: **0 051 534**
**B1**

(12) EUROPEAN PATEI

(45) Date of publication of patent specification: **14.05.86**

(51) Int. Cl.⁴: **H 01 L 21/82, H 01 L 21/30**

(21) Application number: **81401722.4**

(22) Date of filing: **28.10.81**

(54) **A method of fabricating a self-aligned integrated circuit structure using differential oxide growth.**

(30) Priority: **29.10.80 US 201873**

(43) Date of publication of application:
**12.05.82 Bulletin 82/19**

(45) Publication of the grant of the patent:
**14.05.86 Bulletin 86/20**

(84) Designated Contracting States:
**DE FR GB IT NL**

(56) References cited:
**EP-A-0 030 147**
**EP-A-0 034 341**
**US-A-4 210 993**

**IBM TECHNICAL DISCLOSURE BULLETIN, Vol. 22, No. 9, February 1980, New York H. YEH "Self-Aligned Integrated NPN (Vertical) and PNP (Lateral) Structures"**
**IBM TECHNICAL DISCLOSURE BULLETIN Vol. 24, No. 1b, June 1981, New York D. ISAAC et al. "Integration of High-Performance Vertical PNP and NPN transistors"**
**IBM TECHNICAL DISCLOSURE BULLETIN Vol. 22, No. 3, August 1979, New York R. SILVERMAN et al. "Low Temperature Oxidation Method for Self-Passivation of Polysilicon Conductors During Gate Oxide Growth"**

(73) Proprietor: **FAIRCHILD CAMERA & INSTRUMENT CORPORATION**
**464 Ellis Street**
**Mountain View California 94042 (US)**

(72) Inventor: **Vora, Madhukar B.**
**110 Lansbury Court**
**Los Gatos California 95030 (US)**

(74) Representative: **Chareyron, Lucien et al**
**Schlumberger Limited Service Brevets c/o Giers**
**12, place des Etats Unis B.P. 121**
**F-92124 Montrouge Cédex (FR)**

EP 0 051 534 B1

Courier Press, Leamington Spa, England.

## Description

### Background of the Invention

*Field of the Invention*

This invention relates to methods of fabricating integrated circuit structures, and in particular to a technique for fabricating such structures in which the difference in rate of growth of silicon dioxide between lightly and heavily doped silicon is used to create a self-aligned transistor structure.

*Prior Art*

Methods of creating self-aligned transistor structures have been the subject of numerous technical papers and patents. Self-alignment refers to the technique by which regions of an integrated circuit structure are formed in a desired location by using regions on the surface of the structure previously formed to serve other purposes. One example of a self-aligned structure is a metal-oxide-semiconductor transistor in which a gate electrode, formed on the surface of the semiconductor structure, is used as a mask for the diffusion of impurities into the semiconductor structure which impurities form the source and drain regions of the transistor. An example of such a technique is described in US patent US—A—4210993. Processes using self-alignment techniques, because they eliminate masking steps, eliminate the dimensional tolerances associated with the masking steps. Self-aligned processes thereby allow fabrication of smaller, more precisely located, regions in integrated circuit structures.

Oxide isolated integrated circuit structures, and techniques for fabricating them are known. See, e.g., U.S. patent 3,648,125 issued to Douglas Peltzer. Oxide isolated integrated injection logic structures are also known. See, e.g., U.S. Patent 3,962,717 to O'Brien and "Isoplanar Integrated Injection Logic" Journal of Solid State Circuits Vol. SC 12, No. 2, April, 1977, to Hennig, et al. Prior art techniques for fabricating oxide isolated integrated injection logic circuits, and the self-alignment techniques used therein, have required an unnecessarily large number of process and masking steps, thereby reducing the yield of such processes.

### Summary of the Invention

This invention provides a method using relatively few process steps for creating self-aligned emitter-base regions in a bipolar transistor, or collector-base regions in an upward integrated injection logic transistor. The invention relies upon the different oxidation rates of lightly doped and heavily doped silicon. In one embodiment heavily doped polycrystalline silicon regions are formed on the surface of an integrated circuit structure to serve as electrical connections to regions of impurity, to be formed later beneath them, for example, collectors of transistors. When the lightly doped silicon substrate and the heavily doped polycrystalline silicone are oxidized, a substantially thicker layer of silicon dioxide will form on the heavily doped silicon than on the lightly doped substrate. The integrated circuit structure is then uniformly etched to remove the silicon dioxide from the surface of the substrate, but not from the surface of the heavily doped contacts (where the oxide layer was substantially thicker). A suitable dopant may then be applied to the substrate between the contacts. When this dopant is diffused into the substrate, impurities from the heavily doped contacts will also diffuse into the substrate. By appropriate selection of P and N-type dopants for the polycrystalline silicon and the substrate, PN junctions may be formed in the substrate beneath the oxide surrounding the heavily doped contacts.

More generally, a method for fabricating an integrated circuit structure according to one embodiment of the invention includes the steps of forming first regions of doped semiconductor material on an underlying semiconductor substrate, oxidizing the substrate and the first regions to create a layer of oxidized material, removing a substantially uniform layer of the oxidized material from the substrate and the first regions, the uniform layer removed being sufficient to expose the substrate but not expose the first regions, and introducing impurities into the substrate between the first regions and into the substrate from the first regions. It is an object of this invention to simplify the process for fabricating a self-aligned collector-base or emitter-base integrated circuit structure. It is a further object of the invention to eliminate several masking and other process steps from the manufacture of integrated injection logic circuits.

### Brief Description of the Drawings

Fig. 1 is a cross-sectional view of an oxide isolated semiconductor structure fabricated utilizing known techniques.

Fig. 2 is a subsequent cross-sectional view showing how portions of the structure shown in Fig. 1 have been removed.

Fig. 3 is a subsequent cross-sectional view showing the structure after growth of a layer of silicon dioxide.

Fig. 4 is a subsequent cross-sectional view showing the appearance of the structure after removal of a substantially uniform layer of silicon dioxide.

Fig. 5 is a subsequent cross-sectional view showing the appearance of the structure after introduction of further impurities and fabrication of a metal interconnecting layer.

### Detailed Description

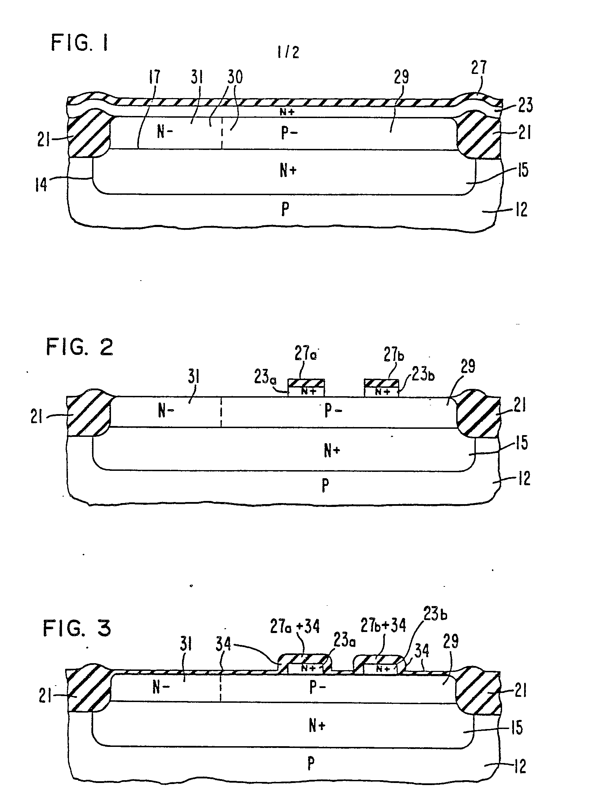

Fig. 1 is a cross-sectional view of an integrated circuit structure which may be fabricated utilizing well-known techniques. As shown in Fig. 1, a P-conductivity type semiconductor silicon substrate 12 of 5—10 ohm-cm resistivity has an N conductivity type buried layer 15 of 25 ohms per square sheet resistance formed to electrically isolate an epitaxial layer 30 by a laterally extending PN junction 14. Epitaxial layer 30 is surrounded by an annular shaped region of insulating material 21, typically silicon dioxide. An N-conductivity type layer of polycrystalline silicon about 500 nm (5000 angstroms) thick is deposited across the upper surface of epitaxial layer 30 with a layer 27 of silicon dioxide about 3000 angstroms thick.

The structure shown in Fig. 1 may be fabricated using known integrated circuit fabrication techniques. See, for example, the techniques shown in U.S. patent 3,648,125 issued to Peltzer. Briefly, substrate 12 is masked and an N-conductivity type impurity, for example, antimony, diffused to form what will become buried layer 15 in the surface 17 of P-conductivity type semiconductor substrate 12. An epitaxial layer of silicon 30 is then deposited across the upper surface 17 of buried layer 15 and substrate 12. In one embodiment, layer 30 is formed by epitaxially depositing monocrystalline silicon having a resistivity of 15 ohm-cm to a thickness of about 1 micron.

Annular grooves are then etched in the epitaxial layer 30, and layer 30 is oxidized, to create oxide isolation 21. The combination of buried layer 15 and the annular region of silicon dioxide 21 will electrically isolate epitaxial material 30 from surrounding portions of the integrated circuit structure. As will be described, active and passive electronic components will be formed in epitaxial material 30. Epitaxial layer 30 may be doped to the desired conductivity type using well-known masking and ion implantation or diffusion techniques. In the embodiment depicted in Fig. 1, the epitaxial layer 30 is deposited as N-conductivity type 31, and then region 29 is formed by diffusing a P-conductivity type impurity, for example, boron, at a low doping level, for example, at $5 \times 10^{16}$ atoms per cubic centimeter, into expitaxial layer 30. Transitors will be formed in region 29 while a portion of region 31 will serve as an electrical connection between the upper surface of the integrated circuit structure and buried layer 15.

Across the upper surface of the structure a layer of polycrystalline silicon 23 is formed. This layer is heavily doped with a strongly N-conductivity type impurity and, as such, is designated N+ in Fig. 1. Typically layer 23 is approximately 500 nm (5000 angstroms) thick formed by chemical vapor deposition and doped with phosphorous or arsenic. In the preferred embodiment, layer 23 is converted to N+ type by ion implantation with a phosphorous dose of $5 \times 10^{15}$ atoms per square centimeter to create an impurity concentration of $10^{20}$ atoms per cubic centimeter concentrated in the center of layer 23. Later processing will cause this impurity to diffuse throughout layer 23. On the upper surface of polycrystalline silicon layer 23, a layer of silicon dioxide 27 is formed to a thickness of about 300 nm (3000 angstroms). Layer 23 may be formed using a known chemical vapor deposition process.

Using silicon dioxide layer 27 as a mask, the N+ polycrystalline silicon 23 is patterned to form regions 23a and 23b. In the preferred embodiment, this is accomplished by using known photolithographic techniques to mask and define regions 27a and 27b in oxide layer 27. The undesired portions of oxide layer 27 are removed using either a chemical or plasma etching. The oxide regions 27a and 27b serve as a mask for the subsequent etching of polycrystalline silicon 23 to define regions 23a and 23b. The appearance of the structure after removal of the undesired portions of polycrystalline silicon 23 and silicon dioxide 27 is shown in Fig. 2.

The structure is then oxidized to form layer 34 across the surface of epitaxial material 29 and 31, on the exposed portions of polycrystalline silicon regions 23a and 23b, and on oxide regions 27a and 27b. The oxidation is typically carried out at a low temperature, for example 800°C for 120 minutes, and approximately 200 angstroms of oxide 34 will form on the epitaxial layer. The low temperature prevents the N+ conductivity type impurities in polycrystalline silicon 23a and 23b from diffusing into the surface of the epitaxial layer 29 beneath them.

Because thermal oxidation proceeds more rapidly on heavily doped silicon, the oxide regions on the sides of polycrystaline silicon regions 23a and 23b will be substantially thicker than the regions formed directly on epitaxial silicon. For example, if oxide 34 on epitaxial material 29 is approximately 200 angstroms thick, oxide 34 on the side of region will be approximately 1000 angstroms thick. The different reaction of oxygen with lightly and heavily doped silicon is discussed in an article by Ho, et al., entitled "Thermal Oxidation of Heavily Doped Silicon", Journal of the Electrochemical Society, Vol. 125, page 665 (1978). The thicker regions of silicon dioxide are shown in Fig. 3. On the upper surface of regions 23a and 23b the thicker regions are designated as "23 + 34" to show that the silicon dioxide formed in these locations further thickens existing oxide regions 27a and 27b. The difference in oxide thickness between the oxide grown on regions 23a and 23b and the oxide grown on regions 29 and 31 will be used to advantage as shown in subsequent figures.

Next, using known techniques of either plasma etching or sputtering etching, the oxide layer 34 is etched. The etching process is allowed to proceed long enough to remove the relatively thin layer of oxide 34 over the epitaxial material 29 and 31, but not to remove the oxide from the sides of regions 23a and 23b. In one embodiment, this is accomplished by plasma or sputter etching. The Tegal Corporation, 528 Weddell Drive, Sunnyvale, California 95086, can perform this process step using their product known as "Plasma Etcher".

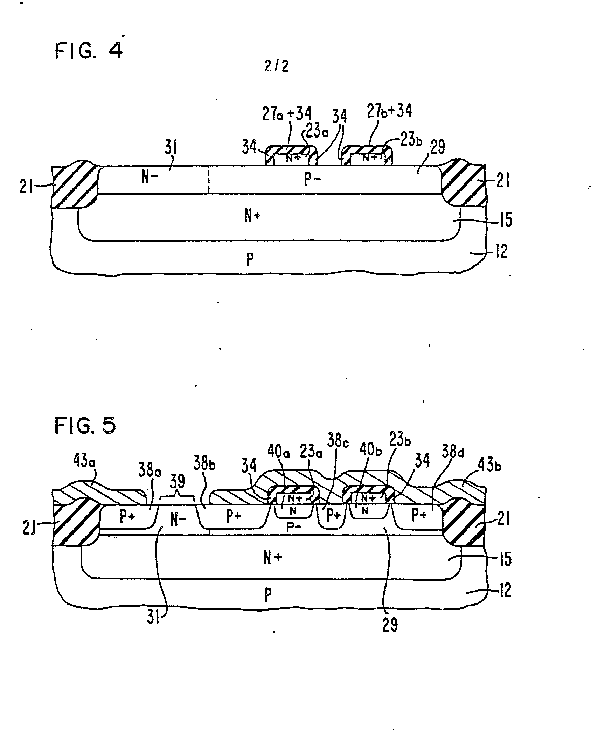

The appearance of the structure after etching is shown in Fig. 4. Enough silicon dioxide is left on the surfaces of regions 23a and 23b to electrically insulate these regions from any subsequently formed overlying layers of material. Almost no silicon dioxide is removed from the sides of region 23a and 23b, and an insignificant amount is removed from the top of regions 23a and 23b.

Using known masking and diffusion or ion implantation techniques, additional regions of impurities 38a, 38b, 38c, and 38d may be formed in epitaxial regions 29 and 31. Regions 38a and 38b will function as the emitter and collector, respectively, of a lateral transistor. P conductivity type impurity is not diffused into a portion 39 of epitaxial layer 31. Region 39 has a resistivity of 0.4 ohm-centimeters and functions as the base of a lateral PNP transistor. In one embodiment, boron is the P+ conductivity type impurity used to create regions 38a—38d at an impurity concentration of $10^{20}$ atoms per cubic centimeter.

As also shown in Fig. 5, at the same time the P+ conductivity type impurity is diffused into the epitaxial material 29 and 31, the high temperature (on the order of 1000°C) will cause the N conductivity type impurity to diffuse out of polycrystalline silicon regions 23a and 23b and create N type regions 40a and 40b in epitaxial silicon 29. The sheet resistance of regions 40a and 40b will be about 10—20 ohms per square. Each of the regions 40a and 40b will function as the collector of an inverted vertical transistor having an emitter 15 and a base 29. The oxide layer 34 on the side of polycrystalline silicon regions 23a and 23b will protect the PN junctions formed in epitaxial material 29.

Finally, as shown in Fig. 5, suitably patterned regions of metal interconnections 43a and 43b may be formed across the surface of the structure using known techniques. The connections depicted in Fig. 5 are to the P+ conductivity regions 38a, 38b, 38c, and 38d. At other cross sections appropriate connections may be made to the collector contact regions 23a and 23b and to buried layer 15 by electrical connection to region 39. Additional layers of insulating material and/or electrical connections may be formed across the surface of the structure shown in Fig. 5 using known techniques.

The structure shown in Fig. 5 has a vertical NPN transistor with a base resistance of about 10 ohms compared to conventional structures which had base resistance on the order of 1000 ohms. The method of fabricating this structure is simpler than prior processes, requiring fewer process steps and fewer masks, and results in a smaller structure.

Although the invention has been described with reference to a specific embodiment, the description is intended to be illustrative of the invention and not to be construed as limiting the invention. Various modifications and applications will occur to those skilled in the art without departing from the scope of the invention as defined by the appended claims. For example, opposite conductivity types may be used in place of those shown in the drawings and discussed herein to accomplish the same results.

## Claims

1. A method for fabricating an integrated circuit structure comprising:
   forming at least one first region (23a) of doped semiconductor material above an underlying semiconductor substrate (30); the first region being heavily doped in relation to the semiconductor substrate
   oxidizing the substrate (30) and the at least one first region (23a) to create a non uniform layer (34) of oxidized semiconductor material which is thicker on the at least one first region than on the substrate;
   removing a substantially uniformly thick layer of the oxidized semiconductor material (34) from the substrate (30) and from the at least one first region (23a), the uniform layer removed being sufficient to expose the substrate (30) but not the at least one first region (23a); and
   introducing impurities (38a, b, c, d) into the exposed substrate (30) adjacent the at least one first region (23a);
   characterized by:
   forming said at least one first region (23a) directly on the surface of said substrate (30); and
   introducing impurities (40a) into the substrate (30) from the at least one first region (23a).

2. A method as in claim 1, characterized in that the at least one first region (23a) of doped semiconductor material is first conductivity type and the impurity (38a, b, c, d) introduced into the substrate (30) adjacent the at least one first region 23 is opposite conductivity type.

3. A method as in claim 1 or 2, characterized in that the substrate (30) is a pocket of epitaxial semiconductor material;
   forming a buried layer (15) of doped semiconductor material beneath the pocket; and
   surrounding the pocket by an annular shaped region (21) of oxidized semiconductor material.

4. A method as in any one of claims 1 to 3, characterized in that the at least one first region (23a) comprises polycrystalline silicon; and
   the substrate (30) is monocrystalline silicon.

5. A method as in any one of claims 1 to 4, characterized in that the at least one region (23a) is formed by:
   depositing a layer (23) of semiconductor material;
   doping the deposited layer (23);
   forming a layer (27) of an oxide of the deposited material on the upper surface thereof; and
   removing undesired portions of the layer of oxide (27) and the layer of semiconductor material (23).

6. A method as in any one of claims 3 to 5, characterized in that at least that portion (29) of the epitaxial layer (30) beneath the at least one first region (23a) is doped with opposite conductivity type impurity to the remaining portions (31) of the epitaxial layer (30).

## Patentansprüche

1. Verfahren zur Herstellung einer integrierten Stromkreisstruktur, umfassend:
   Ausbilden wenigstens eines ersten Bereichs (23a) aus dotiertem Halbleitermaterial über einem darunter liegenden Halbleitersubstrat (30), wobei der erste Bereich in bezug auf das Halbleitersubstrat stark dotiert ist;

Oxidieren des Substrats (30) und des wenigstens eines ersten Bereichs (23a), um eine nicht gleichförmige Schicht (34) aus oxidiertem Halbleitermaterial zu erzeugen, die auf dem wenigstens einen ersten Bereich dicker als auf dem Substrat ist;

Entfernen einer im wesentlichen gleichmäßig dicken Schicht aus oxidiertem Halbleitermaterial (34) von dem Substrat (30) und von dem wenigstens einen ersten Bereich (23a), wobei die gleichmäßige Schicht, die entfernt wurde, ausreichend ist, um das Substrat (30), aber nicht den wenigstens einen ersten Bereich (23a) freizulegen; und

Einbringen von Verunreinigungen (38a, b, c, d) in das freigelegte Substrat (30) benachbart zu dem wenigstens einen ersten Bereich (23a);

gekennzeichnet durch:

Ausbilden des besagten wenigstens einen ersten Bereichs (23a) direkt auf der Oberfläche des besagten Substrats (30); und

Einbringen von Verunreinigungen (40a) in das Substrat (30) von dem wenigstens einen ersten Bereich (23a).

2. Verfahren wie in Anspruch 1, dadurch gekennzeichnet, daß der wenigstens eine erste Bereich (23a) des dotierten Halbleitermaterials von einem ersten Leitfähigkeitstyp und die Verunreinigung (38a, b, c, d), die in das Substrat (30) benachbart zu dem wenigstens einen ersten Bereich (23a) eingebracht ist, von entgegengesetzten Leitfähigkeitstyp ist.

3. Verfahren wie in Anspruch 1 oder 2, dadurch gekennzeichnet, daß das Substrat (30) eine Tasche aus epitaxialem Halbleitermaterial ist.

wobei eine vergrabene Schicht (15) aus dotiertem Halbleitermaterial unter der Tasche gebildet und

die Tasche durch einen ringförmigen Bereich (21) aus oxidiertem Halbleitermaterial umgeben wird.

4. Verfahren wie in einem der Ansprüche 1 bis 3, dadurch gekennzeichnet, daß der wenigstens eine erste Bereich (23a) polykristallines Silicium umfaßt und

das Substrat (30) monokristallines Silicium ist.

5. Verfahren wie in einem der Ansprüche 1 bis 4, dadurch gekennzeichnet, daß der wenigstens eine erste Bereich (23a) hergestellt wird durch:

Niederschlagen einer Schicht (23) aus Halbleitermaterial;

Dotieren der niedergeschlagenen Schicht (23);

Ausbilden einer Schicht (27) eines Oxids des niedergeschalgenen Materials auf der Oberseite hiervon; und

Entfernen ungewünschter Abschnitte der Oxidschicht (27) und der Schicht aus Halbleitermaterial (23).

6. Verfahren wie in einem der Ansprüche 3 bis 5, dadurch gekennzeichnet, daß wenigstens derjenige Abschnitt (29) der Epitaxialschicht (30) unter dem wenigstens einen ersten Bereich (23a) mit einer Verunreinigung vom entgegengesetzten Leitfähigkeitstyp zu den vergleibenden Abschnitten (31) der Epitaxialschicht (30) dotiert ist.

**Revendications**

1. Procédé de fabrication d'une structure de circuit intégré comprenant les étapes suivantes:

former au moins une première région (23a) de matériau semi-conducteur dopé au-dessus d'un substrat semi-conducteur (30) sous-jacent, la première région étant fortement dopée par rapport au substrat semi-conducteur;

oxyder le substrat (30) et la première région (23a) pour créer une couche non uniforme (34) de matériau semi-conducteur oxydé dont l'épaisseur est plus élevée sur la première région que sur le substrat;

enlever du substrat (30) et de la première région (23a) une couche d'épaisseur sensiblement uniforme de matériau semi-conducteur oxydé (34), la couche uniforme enlevée étant suffisante pour exposer le substrat (30) mais non la première région (23a); et

introduire des impuretés (30a, b, c, d) dans le substrat exposé (30) à côté de la première région (23a);

caractérisé par les étapes suivantes:

former la première région (23a) directement sur la surface dudit substrat (30); et

introduire des impuretés (40a) dans le substrat (30) à partir de la première région (23a).

2. Procédé selon la revendication 1, caractérisé en ce que la première région (23a) de matériau semi-conducteur dopé est d'un premier type de conductivité et l'impureté (38a, b, c, d) introduite dans le substrat (30) à côté de la première région (23) est d'un type de conductivité opposé.

3. Procédé selon la revendication 1 ou 2, caractérisé en ce que le substrat (30) est une poche de matériau semi-conducteur épitaxial, et en ce qu'il comprend les étapes suivantes:

former une couche enterrée (15) de matériau semi-conducteur dopé sous la poche; et

entourer la poche par un région (21) de forme annulaire de matériau semi-conducteur oxydé.

4. Procédé selon l'une des revendications 1 à 3, caractérisé en ce que la première région est formée de silicium polycristallin; et

le substrat (30) est formé de silicium monocristallin.

5. Procédé selon l'une des revendication 1 à 4, caractérisé en ce que ladite première région (23a) est formée par les étapes suivantes:

déposer une couche (23) de matériau semi-conducteur;

doper le couche déposée (23);

former une couche (27) d'un oxyde du matériau déposé sur sa surface supérieure; et

enlever des parties indésirables de la couche d'oxyde (27) et de la couche de matériau semi-conducteur (23).

6. Procédé selon l'une des revendications 3 à 5, caractérisé en ce que au moins la partie (29) de couche épitaxiale (30) située sous la première région (23a) est dopée par des impuretés de type de conductivité opposé aux parties restantes (31) de la couche épitaxiale (30).

FIG. I

1/2

FIG. 2

FIG. 3

1

FIG. 4

FIG. 5